# EUROPEAN PATENT SPECIFICATION

(11) **EP 4 089 643 B1**
(45) Date of publication and mention of the grant of the patent: **17.12.2025**
(21) Application number: 22171426.4
(22) Date of filing: 03.05.2022
(51) Int. Cl.: G06T 15/50

(54) **LIGHTING PROBE PLACEMENT SYSTEM AND METHOD**
SYSTEM UND VERFAHREN ZUR PLATZIERUNG EINER BELEUCHTUNGSSONDE
SYSTÈME ET PROCÉDÉ DE MISE EN PLACE DE SONDE D'ÉCLAIRAGE

(30) Priority: 11.05.2021 GB 202106698
(43) Date of publication of application: 16.11.2022
(73) Proprietor: Sony Interactive Entertainment Inc., Tokyo 108-0075 (JP)
(72) Inventor: CAPPELLO, Fabio, London, W1F 7LP (GB); CERRATO, Maurizio, London, W1F 7LP (GB); MONTI, Maria Chiara, London, W1F 7LP (GB); LEONARDI, Rosario, London, W1F 7LP (GB)
(74) Representative: D Young & Co LLP

(56) References cited:
- UNITY TECHNOLOGIES: "Unity - Manual: Light Probe Groups", 27 October 2020 (2020-10-27), XP055882214, Retrieved from the Internet <URL:https://web.archive.org/web/20201027073722/https://docs.unity3d.com/Manual/class-LightProbeGroup.html> [retrieved on 20220121]
- UNITY TECHNOLOGIES: "Unity - Manual: Light Probes", 27 October 2020 (2020-10-27), XP055882268, Retrieved from the Internet <URL:https://web.archive.org/web/20201027003530/https://docs.unity3d.com/Manual/LightProbes.html> [retrieved on 20220121]
- UNITY TECHNOLOGIES: "Unity - Manual: Reflection Probes", 27 November 2020 (2020-11-27), XP055882279, Retrieved from the Internet <URL:https://web.archive.org/web/20201127125530/https://docs.unity3d.com/Manual/ReflectionProbes.html> [retrieved on 20220121]
- UNITY TECHNOLOGIES: "Unity - Manual: Introduction to lighting", 25 October 2020 (2020-10-25), XP055882276, Retrieved from the Internet <URL:https://web.archive.org/web/20201025233536/https://docs.unity3d.com/Manual/LightingInUnity.html> [retrieved on 20220121]
- EINABADI FARSHAD ET AL: "Deep Neural Models for Illumination Estimation and Relighting: A Survey", vol. 40, no. 6, 9 September 2021 (2021-09-09), Oxford, pages 315 - 331, XP055882236, ISSN: 0167-7055, Retrieved from the Internet <URL:https://onlinelibrary.wiley.com/doi/full-xml/10.1111/cgf.14283> DOI: 10.1111/cgf.14283
- DAI PENG ET AL: "PBR-Net: Imitating Physically Based Rendering Using Deep Neural Network", IEEE TRANSACTIONS ON IMAGE PROCESSING, vol. 29, 1 January 2020 (2020-01-01), USA, pages 5980 - 5992, XP093014501, ISSN: 1057-7149, Retrieved from the Internet <URL:http://www.liushuaicheng.org/TIP/PBR-Net/PBRNet-TIP.pdf> DOI: 10.1109/TIP.2020.2987169
- OST JULIAN ET AL: "Neural Scene Graphs for Dynamic Scenes", 2021 IEEE/CVF CONFERENCE ON COMPUTER VISION AND PATTERN RECOGNITION (CVPR), 5 March 2021 (2021-03-05), pages 2855 - 2864, XP093014505, ISBN: 978-1-6654-4509-2, Retrieved from the Internet <URL:https://arxiv.org/pdf/2011.10379.pdf> DOI: 10.1109/CVPR46437.2021.00288
- WEI XIN ET AL: "Object-Based Illumination Estimation with Rendering-Aware Neural Networks", 16 November 2020, 16TH EUROPEAN CONFERENCE - COMPUTER VISION - ECCV 2020, PAGE(S) 380 - 396, XP047588565
- YUE WANG ET AL: "Fast non-uniform radiance probe placement and tracing", INTERACTIVE 3D GRAPHICS AND GAMES, ACM, 2 PENN PLAZA, SUITE 701NEW YORKNY10121-0701USA, 21 May 2019 (2019-05-21), pages 1 - 9, XP058433841, ISBN: 978-1-4503-6310-5, DOI: 10.1145/3306131.3317024
- KEIM ROBERT: "Training Datasets for Neural Networks: How to Train and Validate a Python Neural Network", 30 January 2020 (2020-01-30), XP093015615, Retrieved from the Internet <URL:https://www.allaboutcircuits.com/technical-articles/training-dataset-neural-network-how-to-train-validate-python-neural-network/> [retrieved on 20230119]

## Description

### BACKGROUND OF THE INVENTION

### Field of the invention

The present invention relates to lighting probe placement, in particular using machine learning.

Currently, global illumination (Gl) and reflection probe placement tends to be a long process that starts with an initial placement of probes, for example in a grid pattern, followed by a process of elimination for example to remove probes that collide with geometry, cause light leaking, and so on. This requires the supervision of an artist or designer who examines the scene and moves or eliminates probes in an effort to improve the appearance of a lit scene. This process is then repeated in an ad-hoc manner for each scene in a game (or other rendered environment, such as in a film).

The results may be visually satisfying, but are laborious and typically still include an unnecessary number or placement of probes, increasing computational overhead.

The present invention seeks to address or mitigate this problem.

### Prior-Art Disclosure:

The document "Unity - Manual: Light Probe Groups" by Unity Technologies and found at // docs.unity3d.com/Manual/class-LightProbeGroup.html allows the manual placement of light probes for rendering a virtual scene.

### SUMMARY OF THE INVENTION

The present invention is defined by the appended independent claims.

In a first aspect, a lighting probe placement system for estimating lighting probe positions within a virtual environment is provided in accordance with claim 1.

In another aspect, a method of estimating lighting probe positions within a virtual environment is provided in accordance with claim 12.

In another aspect, a method of training a machine learning system to use in any one of the preceding aspects is provided in accordance with claim 13.

Various aspects and features of the present invention are defined in the appended claims and within the text of the accompanying description.

### BRIEF DESCRIPTION OF THE DRAWINGS

A more complete appreciation of the disclosure and many of the attendant advantages thereof will be readily obtained as the same becomes better understood by reference to the following detailed description when considered in connection with the accompanying drawings, wherein:
- Figure 1 is a schematic diagram of an entertainment device in accordance with embodiments of the present description;
- Figure 2 is a flow diagram of a method of estimating lighting probe positions within a virtual environment in accordance with embodiments of the present description; and
- Figure 3 is a flow diagram of a method of training a machine learning system in accordance with embodiments of the present description.

A system and method of lighting probe placement are disclosed. In the following description, a number of specific details are presented in order to provide a thorough understanding of the embodiments of the present description. It will be apparent, however, to a person skilled in the art that these specific details need not be employed to practice the present invention. Conversely, specific details known to the person skilled in the art are omitted for the purposes of clarity where appropriate.

In an example embodiment of the present description, an entertainment system such as a videogame console, or equivalently a development kit for such an entertainment system, or a computer or server used in development for such an entertainment system may implement a method of illumination and reflection probe placement as described elsewhere herein.

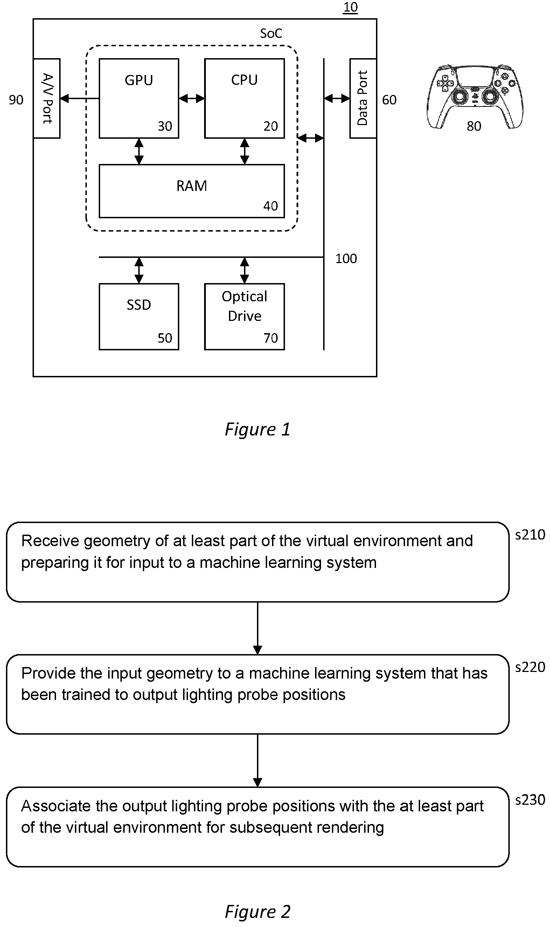

Referring now to the drawings, wherein like reference numerals designate identical or corresponding parts throughout the several views, then Figure 1 shows an example of such an entertainment system 10. This entertainment system could for example be a Sony ^{®} PlayStation 5 ^{®} (PS5), or a similar videogame console, personal computer, or other computing device, or a development kit for such a device.

The entertainment system 10 comprises a central processor 20. This may be a single or multi core processor, for example comprising eight cores. The entertainment system also comprises a graphical processing unit or GPU 30. The GPU can be physically separate to the CPU, or integrated with the CPU as a system on a chip (SoC).

The entertainment device also comprises RAM 40, and may either have separate RAM for each of the CPU and GPU, or shared RAM. The or each RAM can be physically separate, or integrated as part of an SoC. Further storage is provided by a disk 50, either as an external or internal hard drive, or as an external solid state drive, or an internal solid state drive.

The entertainment device may transmit or receive data via one or more data ports 60, such as a USB port, Ethernet ^{®} port, WiFi ^{®} port, Bluetooth ^{®} port or similar, as appropriate. It may also optionally receive data via an optical drive 70.

Interaction with the system is typically provided using one or more handheld controllers 80, but may be via a mouse/keyboard, gestures or other suitable user interfaces.

Audio/visual outputs from the entertainment device are typically provided through one or more A/V ports 90, or through one or more of the wired or wireless data ports 60.

Where components are not integrated, they may be connected as appropriate either by a dedicated data link or via a bus 100.

Operating under suitable software instruction, the entertainment device or equivalent development kit, computer or server, may then implement a method of global illumination and reflection probe placement as follows.

It will be appreciated that a typical virtual scene, which may be for use in a video game, or as a TV or movie set, may comprise ambient light (for example generated by a so-called sky box) and/or directional light (typically from in-environment light sources).

However a further form of lighting comes from global illumination ('GI'), which accounts for secondary light sources such as bounced or reflective light, or optionally emissive light from textured objects. Similarly reflection can redirect light toward other surfaces and toward the virtual camera.

The calculation of such secondary light can be performed using global illumination probes ('GI probes') and optionally also reflection probes, which collectively may be more generally referred to as lighting probes.

The lighting interaction is typically with static components within the scene, although not necessarily so.

In a typical example, a red cube on a white surface will result in a pink/red tint to the white surface around the cube due to GI. Meanwhile depending on the surface properties of the cube, the surface, or another object, a sharp or diffuse reflection may be seen on the surface of one or more of them.

As noted above, the placement of probes to enable good quality GI, and optionally reflection, can be laborious, and the process of calculating global illumination, and optionally reflection, can be time consuming and is advantageously reduced if there are fewer iterations of GI probe placement or optionally reflection probe placement in this process.

As noted previously, current implementations of GI and reflection probe placement are slow, and involve iteratively moving probes (and sometimes removing or adding probes), under the supervision of an artist or designer, followed each time by re-computation of the lighting in the scene - which itself can be slow - and rendering an image for review. This has to be done ad hoc for every scene in every game. The results are usually visually satisfying, but not always optimal in terms of the number or position of probes. Hence both the process itself and the final result are typically more computationally intensive than is necessary.

Accordingly, embodiments of the present description seek to address or mitigate this issue by determining a suitable GI and optionally reflection probe placement with much less artist supervision required.

Automatic probe placement is performed by a machine learning ('ML') system trained on probe placement examples that reduce and preferably minimise graphics artefacts, and similarly reduce and preferably minimise the number of probes needed for a scene.

The ML system is provided as input with descriptive data of the virtual scene.

Typically this comprises geometry data for that part of the scene to be illuminated based on the current set of probes. This may represent only a part of the scene (e.g. for a large environment using successive sets of probes) or the full scene (e.g. for a smaller environment such as a typical room). Preferably the geometry data is the same as that used for rendering the scene.

Such geometry data can be presented to the ML system for example as a scene graph structure.

Optionally other data may also be provided, such as surface colour data associated with the geometry or derived from textures to be applied to the geometry in the rendering process.

Optionally, this input data can be subjected to any suitable pre-processing, such as dimension reduction (e.g. using an autoencoder, or a non-square matrix multiplication) and other techniques common to machine learning schemes. Dimension reduction, for example, can help to provide a consistent input data size for the machine learning system.

The ML system is trained to output a vector or other data structure comprising position information for one or more probes, and optionally one or more other items of information that may be associated with a probe, such as metadata for occlusions, or one or more probe's influence radius.

The ML system may be trained to output data just for GI probes, or GI and reflection probes, or just for reflection probes. In other words, a machine learning system can be trained just for GI probe placement (with optional additional probe data) or for both GI and reflection probes, either a second ML system or a combined ML system can be used.

Hence the ML system comprises an input suitable to receive geometry data and optionally additional data, or a pre-processed and/or dimension-reduced version thereof, and comprises an output suitable to provide position data and optionally additional data (such as probe influence radius) for the placement of a suitable number of probes.

A typical architecture for such an ML may thus comprise an input layer for the inputs, at least a first hidden layer, and an output layer for the outputs, with a connectivity scheme between the layers that enables an internal representation of the relationship between virtual scenes and probe placements to be modelled. Examples of such an ML include a supervised or semi-supervised neural network architecture, or a reinforcement learning neural network architecture. A deep learning neural network may similarly be considered suitable.

As noted above, the ML uses geometry based input data and generate probe position data as an output. Consequently training data for such an ML comprises at least scene geometry data and preferred probe position data.

The training data may be obtained using one or more of the following techniques.

Firstly, where a virtual scene or set for a TV, film, interactive experience, or game has already been processed to have GI and optionally reflection probes, for example using artistic supervision / curation, then the scene geometry and any optional data, together with the curated probe positions, may be used as training data. Preferably training data from a plurality of such virtual scenes may be used, and more preferably training data from a plurality of different TV, film, interactive experience, or game titles may be used, as these are likely to reflect different lighting requirements, geometric layouts, and optionally colour palettes (e.g. if textures or representations thereof are part of the input).

This approach may be of particular benefit when using similar assets and environments to a previous virtual scene, for example when developing a sequel to or expansion of existing content.

Alternatively or in addition, an ML system may be trained with new training data based for example on a representative sample of virtual scenes from the new content. This new training data may also be generated in the supervised and curated manner described previously herein. However, for a system intended to minimise or avoid the need for such supervision, it may be reasonable to assume that such supervised curation may not be available for the purposes of generating training data.

Therefore it is preferable to be able to generate such training data automatically. It will be appreciated that if it is possible to generate probe position data automatically, then the approach used to generate the training data itself could in theory be used to generate actual probe placement solutions for the virtual scene. However, as explained below, the available techniques are computationally very expensive.

Firstly, for a given training pair of inputs and outputs, it is useful to generate a ground truth or ideal image in which the virtual scene is rendered fully including lighting and optionally reflection, for example by using ray tracing.

Any subsequent automatic process for approximating this image using global illumination probes and optionally reflection probes during a render is then evaluated against this ground truth. A particular distribution of global illumination probes and optionally reflection probes is then deemed the target distribution if the resulting rendered image best matches the ground truth image, or matches it to a threshold degree. In this latter case, it will be appreciated that potentially a number of probe distributions for the same scene may generate rendered images that match the ground truth image to a threshold degree; in this case some or all of these distributions are used for training, which in turn may improve the resilience and robustness of the machine learning system, but possibly at a cost of a slight reduction in fidelity due to also learning acceptable but less optimal distributions than that of the best matching rendered image.

Algorithms for generating such probe distributions include the following.

### i. Brute force algorithm

Such an algorithm starts with the scene and places probes randomly or following a predetermined sampling pattern such a uniform sampling, e.g. on a volumetric grid. Alternatively the initial random or grid based distribution can be chosen responsive to the existing scene geometry, for example with the probe density of a given volume being a function of the number of polygons of the scene geometry falling within that volume, with more geometry giving rise to more (or more densely placed) probes.

The scene is then rendered using the preferred rendering method (typically the production method, i.e. that which will be used during use of the virtual scene, such as traditional rasterization based rendering) and an image is produced.

This image is compared with the ray traced ground truth image, rendered from the same camera position, and an error or difference between the two images is calculated, as described later herein. This is repeated until the error is minimised or is less than a threshold amount, and the corresponding probe number and placement is recorded.

An example of such an algorithm is the random search algorithm. After having found a probe placement for that scene with the best (or threshold-acceptable) result, the probe positions and optionally metadata of the ideal placement are used as output targets of the training data for the ML model in conjunction with the geometry of the scene (without probes) as the input.

### ii. Genetic or random noise algorithm

Such an algorithm starts in a similar manner to the brute force algorithm with regards to initial placement and rendering, but subsequently the positions of one or more probes are perturbed (e.g. randomly) by a small amount (e.g. up to half the separation distance from neighbouring probes) between each test render. Perturbations that reduce the error are kept, whilst those that do not are discarded. The size of the perturbations can be reduced either as a function of the number of successive tests and/or as a function of the error size, becoming smaller as the error becomes smaller.

### iii. Mock gradient descent algorithm

Whilst it is difficult to directly relate a probe-position based gradient to the error in a rendered image, it will be appreciated that when a probe is moved in a certain direction, and the error is reduced, it makes sense to move it in that direction again (or optionally in a random direction falling within a cone having an axis parallel with that direction and a bounding surface at a predetermined angle, such as 15, 30, 45 or 60 degrees).

It will also be appreciated however that when multiple probes are moved at the same time, the error may reduce but not necessarily due to the contribution from any one probe's movement, which may actually be detrimental. Therefore the algorithm comprises moving a random subset of probes for each iteration, determining if the error goes up or down, and then moving another random subset of probes - but where a probe is selected again, either moving it in the same direction or within the cone if its previous use corresponded with a reduction in error, and either in the opposite direction or randomly (optionally randomly in a range outside the cone or in a hemisphere opposite the cone) if its previous use corresponded with an increase in error. This approach acts as a form of noisy simultaneous equation approximating a gradient descent, causing probes to tend to move in a direction that reduces the error whenever they are next selected.

Optionally for any of the above techniques, a probe may be randomly turned off, or a new probe randomly added. This may occur at a longer interval than each image iteration. As it is preferable to use fewer probes (to reduce computational overhead), then if turning a probe off does not increase the error (or only increases it by less than a second predetermined amount), optionally by after N subsequent iterations, then it may be kept off. Similarly if adding a probe (for example midway between three other probes in a volume) does not decrease the error by more than a third predetermined amount, optionally by after N subsequent iterations, then it may be removed again.

Each of the above algorithms may optionally start with a small number of probes (for example between 50 and 80% of the number normally used by a human supervisor in a scene of a similar size and/or polygon count) and slowly increase the number over time, evaluating the corresponding return on error performance until for example the marginal benefit of the last probe is below the third predetermined threshold.

Optionally for any of the above techniques, the training data may also include a probe's influence radius. This may be fixed, so that achieving a threshold error is based primarily on placement and number of probes, or may also be make a variable that can be changed according to the same principles as placement in each algorithm, so that the radius of influence of a given probe can also be adjusted. Optionally different algorithms can be employed to refine placement and radius of influence. If a probe is turned on, it can be initialised with a default radius, or if it was previously turned off, optionally can use its previous radius value.

The above algorithms use an error measurement between the rendered image and the ground truth image to determine the suitability of a candidate probe distribution in the virtual scene.

This error measurement may be any suitable comparative measure between two data sets (e.g. image pixels), such as an absolute pixel value difference (because the images are of the same scene and from the same viewpoint, the only difference in pixel values will be due to the lighting).

Preferably a perceptually based comparison of the images may be employed, on the basis that minimising such a metric may also minimise a perceived difference by a user.

Known metrics suitable for perceptually based comparison are the so-called L1 and L2, which are specific instances of the Minkowski metric (See https://en.wikipedia.org/wiki/Minkowski_distance). A description of its use for perceptually based image comparison may be found for example in 'A perceptually based comparison of image similarity metrics', Sinha, P and Russel, R; Perception, 2011, volume 40, pages 1269 - 1281 (http://web.mit.edu/sinhalab/Papers/sinha_russell2011.pdf), incorporated herein by reference.

In summary, the L1 metric is the Manhattan distance or the sum of absolute error, whilst L2 is the Euclidean distance of sum of square error, and hence can be seen as variants on the above approach of absolute pixel value difference. L1 is computationally cheaper to implement. Preference studies also suggest that L1 will produce a slightly better approximation of user perception preferences. Hence preferably the error is based on the L1 metric, but it will be appreciated that L2, or absolute pixel value difference, or any other comparison scheme may be used.

As an example of an alternative scheme, an adversarial network may be trained on target images (e.g. images from existing games, or real-world images) to recognise images that look real, in terms of their lighting. Images rendered using a current distribution of probes could then be scored by the network, with higher scoring images being deemed more realistic. Again, because the scene and viewpoint would not change between iterations of probe placement, any change in score would effectively be independent of the content of the scene itself, and be due to the lighting.

Using any suitable combination of the above approaches, may thus be used to generate training images for the machine learning system. It will be appreciated the as a result the training set is computationally expensive to produce (though less than using these techniques for every scene or viewpoint in production). As a result the training set may be relatively small. To increase the training set size, as noted above images that are within a threshold error of the ground truth image may be used, thereby creating multiple examples for each ground truth image generated and compared against, and similarly data from other projects (typically using the same game engine) can be pooled to increase the size of the training set.

In this latter case, different developers may not want to share geometry data or image data with each other. However, note that the training set itself only requires the target probe placements, not the final image, and the input geometry data can be subjected to a dimension reduction scheme as part of pre-processing, making the geometry effectively unusable by the game engine itself but still suitable for training.

As also noted above, additional sources of training data include previously supervised and curated probe placements, which may be particularly of use for example when developing a sequel or expansion to previous content
The ML is then trained using the training set to output predicted numbers of GI probes, and optionally reflection probes, and further optionally any suitable metadata associated with such probes. The number of generated probes may be fixed (e.g. within the training set and subsequent output) or may vary. In this case, a null placement (for example a placement within a particular region of the scene such as within an object volume, or outside of a scene wall) may signify non-use of a probe both during training and output, when the nodes or other output scheme of the ML are otherwise fixed.

The trained ML can then be integrated into a game engine editor or similar, and provide good quality probe placement for any subsequent content that follows the same physically based lighting model as that used in the ray tracing scheme. Optionally an artist may still then adjust the probe positions if desired, but this process will take much less time than if starting from an initial random or grid based layout. It will also be appreciated that any such changes may also be used to refine the training of the ML.

As noted elsewhere herein, traditionally lighting probe placement has to be done ad hoc for every scene in every game, under manual supervision, resulting in slow throughput and sometimes less than optimal probe usage. Hence both the process itself and the final result are typically more computationally intensive than is necessary.

Embodiments of the present description seek to address or mitigate this issue by determining a suitable GI and optionally reflection probe placement with much less artist supervision required. This advantageously reduces computational load in the selection of probe placement and optionally improves the number of probes selected. Furthermore it typically also improves memory usage, either by virtue of fewer probes or because fewer iterations of probe layout need to be stored during the decision making process. In particular with fewer probes, less computation is required both at so-called 'baking time' and also when traversing the virtual environment to find probes.

In a summary embodiment of the present description, a lighting probe placement system (such as entertainment system 10 or a development kit thereof) for estimating lighting probe positions within a virtual environment comprising the following.

Firstly, a geometry input processor (such as CPU 20, GPU 30, or any suitable combination thereof) configured (for example by suitable software instruction) to receive geometry of at least part of the virtual environment and prepare it for input to a machine learning system, as described elsewhere herein.

Secondly, a processor (such as CPU 20, GPU 30, or any suitable combination thereof) configured (for example by suitable software instruction) to implement the machine learning system, which has been trained to output lighting probe positions upon receiving input geometry of the at least part of the virtual environment, as described elsewhere herein.

And thirdly, an association processor (such as CPU 20, GPU 30, or any suitable combination thereof) configured (for example by suitable software instruction) to associate the output lighting probe positions with the at least part of the virtual environment for subsequent rendering, as described elsewhere herein.

It will be apparent to a person skilled in the art that variations in the above system corresponding to operation of the various embodiments of the method and/or apparatus as described and claimed herein are considered within the scope of the present disclosure, including but not limited to that:
- the lighting probes comprise at least global illumination probes, as described elsewhere herein;
   - in this case, optionally the lighting probes also comprise reflection probes, as described elsewhere herein;
- the input geometry comprises one or more selected from the list consisting of a scene graph structure, and a reduced dimension representation of the input geometry, as described elsewhere herein;
- the input to the machine learning system also comprises one or more selected from the list consisting of geometry metadata, geometry occlusion metadata, and colour information derived from the virtual environment corresponding to the input geometry, as described elsewhere herein;
- A lighting probe placement system according to any preceding claim, in which the output from the machine learning system also comprises one or more selected from the list consisting of probe metadata, and probe radius of influence, as described elsewhere herein;
- the machine learning system has been trained using probe positions obtained under user supervision for corresponding to input geometry, as described elsewhere herein;
- the machine learning system has been trained using target probe positions generated automatically using a lighting probe position evaluation scheme, the scheme comprising selecting a distribution of lighting probe positions within the at least part of the virtual environment corresponding to the input geography; rendering, from a predetermined viewpoint matching a reference viewpoint, an image of at the least part of the virtual environment using the selected distribution of lighting probe positions; comparing the rendered image with a reference image of at the least part of the virtual environment from the same reference viewpoint to determine an image error; altering the distribution of at least some lighting probe positions if the error does not meet a first predetermined criterion, and associating the distribution of lighting probe positions with the at least part of the virtual environment if the error does meet a second predetermined criterion, as described elsewhere herein;
- alternatively, the machine learning system has been trained using target probe positions generated automatically using a lighting probe position evaluation scheme, the scheme comprising selecting a distribution of lighting probe positions within the at least part of the virtual environment corresponding to the input geography; rendering an image of at the least part of the virtual environment using the selected distribution of lighting probe positions; presenting the rendered image to a further machine learning system itself trained to evaluate the lighting of images based on a set of example images; and obtaining an image error value from the further machine learning system, as described elsewhere herein;
   - in either alternate case, optionally the distribution of lighting probe positions is altered by one or more selected from the list consisting of a random redistribution of at least some of the lighting probe positions, a random perturbation of at least some of the lighting probe positions by up to a predetermined amount, and a repositioning of at least some of the lighting probe positions within a range of directions centred on the previous effective direction of a change in position of a probe, if a probe's change to its current position corresponded with a reduction in the image error, as described elsewhere herein; and
   - similarly in either alternate case, optionally the distribution of lighting probe positions is altered by including or excluding lighting probes when rendering the image, as described elsewhere herein.

Meanwhile a virtual content editing system may comprise the lighting probe placement system of any configuration described above, together with a rendering processor operable to render an image of at the least part of the virtual environment using an associated distribution of lighting probe positions generated by the machine learning system, and an output processor operable to output the rendered image for display to a user, as described elsewhere herein.

Turning now to Figure 2, in a corresponding summary embodiment of the present description, a method of estimating lighting probe positions within a virtual environment comprises the following steps.

In a first step s210, receiving geometry of at least part of the virtual environment and preparing it for input to a machine learning system, as described elsewhere herein.

In a second step s220, providing the input geometry to a machine learning system that has been trained to output lighting probe positions, as described elsewhere herein.

And in a third step s230, associating the output lighting probe positions with the at least part of the virtual environment for subsequent rendering, as described elsewhere herein.

Again, it will be apparent to a person skilled in the art that variations in the above method corresponding to operation of the various embodiments of the method and/or apparatus as described and claimed herein are considered within the scope of the present disclosure.

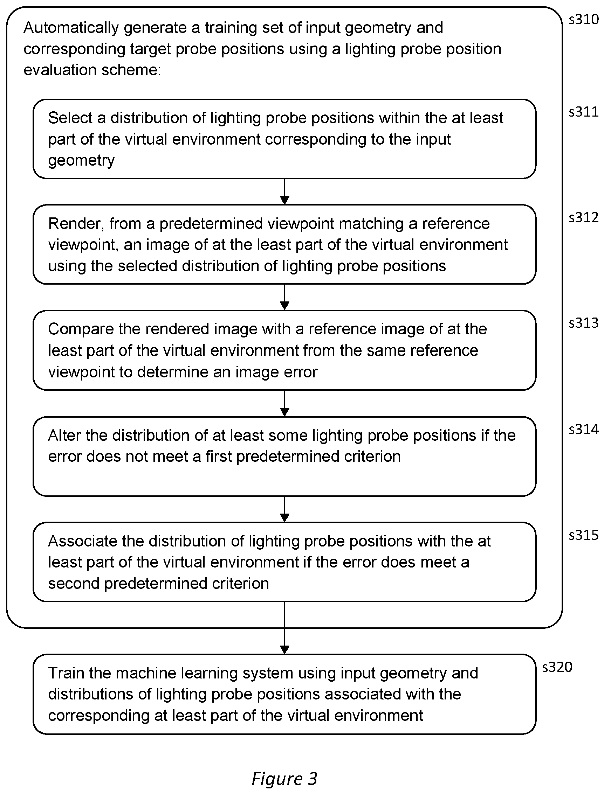

Turning next to Figure 3, in a corresponding summary embodiment of the present description, a method of training a machine learning system to use in either of the above summary embodiment or any of the systems and methods disclosed herein, comprises the following steps.

In a first step s310, automatically generating a training set of input geometry and corresponding target probe positions using a lighting probe position evaluation scheme, as described elsewhere herein, the scheme comprising the following sub-steps.
- In a first sub-step s311, selecting a distribution of lighting probe positions within the at least part of the virtual environment corresponding to the input geometry, as described elsewhere herein;
- In a second sub-step s312 rendering, from a predetermined viewpoint matching a reference viewpoint, an image of at the least part of the virtual environment using the selected distribution of lighting probe positions, as described elsewhere herein;
- In a third sub-step s313, comparing the rendered image with a reference image of at the least part of the virtual environment from the same reference viewpoint to determine an image error, as described elsewhere herein;
- In a fourth sub-step s314, altering the distribution of at least some lighting probe positions if the error does not meet a first predetermined criterion, as described elsewhere herein; and
- In a fifth sub-step s315, associating the distribution of lighting probe positions with the at least part of the virtual environment if the error does meet a second predetermined criterion, as described elsewhere herein.

And in a second step s320, training the machine learning system using input geometry and distributions of lighting probe positions associated with the corresponding at least part of the virtual environment, as described elsewhere herein.

Again, it will be apparent to a person skilled in the art that variations in the above method corresponding to operation of the various embodiments of the method and/or apparatus as described and claimed herein are considered within the scope of the present disclosure, including but not limited to that:
- the distribution of lighting probe positions is altered by one or more selected from the list consisting of a random redistribution of at least some of the lighting probe positions, a random perturbation of at least some of the lighting probe positions by up to a predetermined amount, and a repositioning of at least some of the lighting probe positions within a range of directions centred on the previous effective direction of a change in position of a probe, if a probe's change to its current position corresponded with a reduction in the image error, as described elsewhere herein.

It will be appreciated that the above methods may be carried out on conventional hardware (such as the entertainment device 10 or a development kit thereof) suitably adapted as applicable by software instruction or by the inclusion or substitution of dedicated hardware.

Thus the required adaptation to existing parts of a conventional equivalent device may be implemented in the form of a computer program product comprising processor implementable instructions stored on a non-transitory machine-readable medium such as a floppy disk, optical disk, hard disk, solid state disk, PROM, RAM, flash memory or any combination of these or other storage media, or realised in hardware as an ASIC (application specific integrated circuit) or an FPGA (field programmable gate array) or other configurable circuit suitable to use in adapting the conventional equivalent device. Separately, such a computer program may be transmitted via data signals on a network such as an Ethernet, a wireless network, the Internet, or any combination of these or other networks.

The foregoing discussion discloses and describes merely exemplary embodiments of the present invention.

## Claims

1. A lighting probe placement system for estimating lighting probe positions within a virtual environment, comprising:
a geometry input processor configured to receive geometry of at least part of the virtual environment and prepare it for input to a machine learning system;
a processor configured to implement the machine learning system, which has been trained to output lighting probe positions upon receiving input geometry of the at least part of the virtual environment; and training of the machine learning system comprises:
for a given training pair of inputs and outputs, generating a ground truth image in which a virtual scene is rendered fully including lighting and optionally reflection; and
automatically approximating the ground truth image using global illumination probes and optionally reflection probes during a render; and
determining a number of probe distributions, for which the corresponding rendered images for the same scene match the ground truth image to a threshold degree; and
using some or all of these distributions for training the machine learning system; and
an association processor configured to associate the output lighting probe positions with the at least part of the virtual environment for subsequent rendering.

2. A lighting probe placement system according to claim 1, in which the lighting probes comprise one or more selected from the list consisting of:
i. at least global illumination probes; and
ii. global illumination probes and reflection probes.

3. A lighting probe placement system according to any preceding claim, in which the input geometry comprises one or more selected from the list consisting of:
i. a scene graph structure; and
ii. a reduced dimension representation of the input geometry.

4. A lighting probe placement system according to any preceding claim, in which the input to the machine learning system also comprises one or more selected from the list consisting of:
i. geometry metadata;
ii. geometry occlusion metadata; and
iii. colour information derived from the virtual environment corresponding to the input geometry.

5. A lighting probe placement system according to any preceding claim, in which the output from the machine learning system also comprises one or more selected from the list consisting of:
i. probe metadata; and
ii. probe radius of influence.

6. A lighting probe placement system according to any preceding claim, in which the machine learning system has been trained using probe positions obtained under user supervision for corresponding to input geometry.

7. A lighting probe placement system according to any preceding claim, in which
the machine learning system has been trained using target probe positions generated automatically using a lighting probe position evaluation scheme, the scheme comprising:
selecting a distribution of lighting probe positions within the at least part of the virtual environment corresponding to the input geometry;
rendering, from a predetermined viewpoint matching a reference viewpoint, an image of at the least part of the virtual environment using the selected distribution of lighting probe positions;
comparing the rendered image with the ground truth image of at the least part of the virtual environment from the same reference viewpoint to determine an image error; and
altering the distribution of at least some lighting probe positions if the error does not meet a first predetermined criterion, and
associating the distribution of lighting probe positions with the at least part of the virtual environment if the error does meet a second predetermined criterion.

8. A lighting probe placement system according to any one of claims 1 to 6, in which
the machine learning system has been trained using target probe positions generated automatically using a lighting probe position evaluation scheme, the scheme comprising:
selecting a distribution of lighting probe positions within the at least part of the virtual environment corresponding to the input geometry;
rendering an image of at the least part of the virtual environment using the selected distribution of lighting probe positions;
presenting the rendered image to a further machine learning system itself trained to evaluate the lighting of images based on a set of example images; and
obtaining an image error value from the further machine learning system.

9. A lighting probe placement system according to claim 7 or claim 8, in which the distribution of lighting probe positions is altered by one or more selected from the list consisting of:
i. a random redistribution of at least some of the lighting probe positions;
ii. a random perturbation of at least some of the lighting probe positions by up to a predetermined amount; and
iii. a repositioning of at least some of the lighting probe positions within a range of directions centred on the previous effective direction of a change in position of a probe, if a probe's change to its current position corresponded with a reduction in the image error.

10. A lighting probe placement system according to any one of claims 7 to 9, in which the distribution of lighting probe positions is altered by including or excluding lighting probes when rendering the image.

11. A virtual content editing system, comprising:
the lighting probe placement system of any preceding claim;
a rendering processor operable to render an image of at the least part of the virtual environment using an associated distribution of lighting probe positions generated by the machine learning system; and
an output processor operable to output the rendered image for display to a user.

12. A method of estimating lighting probe positions within a virtual environment, comprising the steps of:
receiving geometry of at least part of the virtual environment and preparing it for input to a machine learning system;
providing the input geometry to a machine learning system that has been trained to output lighting probe positions; and training of the machine learning system comprises:
for a given training pair of inputs and outputs, generating a ground truth image in which a virtual scene is rendered fully including lighting and optionally reflection; and
automatically approximating the ground truth image using global illumination probes and optionally reflection probes during a render; and
determining a number of probe distributions, for which the corresponding rendered images for the same scene match the ground truth image to a threshold degree; and
using some or all of these distributions for training the machine learning system; and
associating the output lighting probe positions with the at least part of the virtual environment for subsequent rendering.

13. A method of training a machine learning system to use in any one of the preceding claims, comprising the steps of:
automatically generating a training set of input geometry and corresponding target probe positions using a lighting probe position evaluation scheme, the scheme comprising:
selecting a distribution of lighting probe positions within the at least part of the virtual environment corresponding to the input geometry;
rendering, from a predetermined viewpoint matching a reference viewpoint, an image of at the least part of the virtual environment using the selected distribution of lighting probe positions;
comparing the rendered image with the ground truth image of at the least part of the virtual environment from the same reference viewpoint to determine an image error; and
altering the distribution of at least some lighting probe positions if the error does not meet a first predetermined criterion, and
associating the distribution of lighting probe positions with the at least part of the virtual environment if the error does meet a second predetermined criterion; and
training the machine learning system using input geometry and distributions of lighting probe positions associated with the corresponding at least part of the virtual environment.

14. The method of claim 13, in which the distribution of lighting probe positions is altered by one or more selected from the list consisting of:
i. a random redistribution of at least some of the lighting probe positions;
ii. a random perturbation of at least some of the lighting probe positions by up to a predetermined amount; and
iii. a repositioning of at least some of the lighting probe positions within a range of directions centred on the previous effective direction of a change in position of a probe, if a probe's change to its current position corresponded with a reduction in the image error.

15. A computer program comprising computer executable instructions which, when executed by a computer system, cause the computer system to perform the method of any one of claims 12 to 14.

## Patentansprüche

1. System zur Platzierung von Beleuchtungssonden zur Schätzung der Positionen von Beleuchtungssonden innerhalb einer virtuellen Umgebung, umfassend:
einen Geometrieeingabeprozessor, der konfiguriert ist, um die Geometrie mindestens eines Teils der virtuellen Umgebung zu empfangen und für die Eingabe in ein maschinelles Lernsystem vorzubereiten;
einen Prozessor, der konfiguriert ist, um die Implementierung des maschinellen Lernsystems zu übernehmen, das darauf trainiert wurde, Beleuchtungssondenpositionen auszugeben, wenn es die Eingabegeometrie mindestens eines Teils der virtuellen Umgebung empfängt; und Trainieren des maschinellen Lernsystems umfasst Folgendes:
für ein gegebenes Trainingspaar aus Eingaben und Ausgaben, Erzeugen eines Referenzbildes, in dem eine virtuelle Szene vollständig gerendert wird, einschließlich Beleuchtung und optional Reflexion; und
automatisches Annähern an das Referenzbild unter Verwendung globaler Beleuchtungssonden und optionaler Reflexionssonden während eines Renderns; und
Bestimmen einer Anzahl von Sondenverteilungen, bei denen die entsprechenden gerenderten Bilder für dieselbe Szene bis zu einem Schwellenwert mit dem Referenzbild übereinstimmen; und
Verwenden einiger oder aller dieser Verteilungen für das Trainieren des maschinellen Lernsystems; und
einen Zuordnungsprozessor, der konfiguriert ist, um die Positionen der Ausgabebeleuchtungssonden mit mindestens einem Teil der virtuellen Umgebung für das anschließende Rendern zu verknüpfen.

2. System zur Platzierung von Beleuchtungssonden nach Anspruch 1, bei dem die Beleuchtungssonden eine oder mehrere aus der Liste umfassen, bestehend aus:
i. mindestens globalen Beleuchtungssonden; und
ii. globalen Beleuchtungssonden und Reflexionssonden.

3. System zur Platzierung von Beleuchtungssonden nach einem der vorstehenden Ansprüche, wobei die Eingabegeometrie eine oder mehrere Geometrien umfasst, ausgewählt aus der Liste, bestehend aus:
i. einer Szenen-Diagramm-Struktur; und
ii. einer Darstellung der Eingabegeometrie in reduzierter Dimension.

4. System zur Platzierung von Beleuchtungssonden nach einem der vorstehenden Ansprüche, wobei die Eingabe in das maschinengelernte System auch eine oder mehrere Angaben aus der Liste umfasst, bestehend aus:
i. Geometriemetadaten;
ii. Metadaten zur Geometrieverdeckung; und
iii. Farbinformationen, die von der virtuellen Umgebung abgeleitet werden und der eingegebenen Geometrie entsprechen.

5. System zur Platzierung von Beleuchtungssonden nach einem der vorstehenden Ansprüche, wobei die Ausgabe aus dem maschinengelernten System auch eine oder mehrere Angaben aus der Liste umfasst, bestehend aus:
i. Sondenmetadaten; und
ii. Sondeneinflussbereich.

6. System zur Platzierung von Beleuchtungssonden nach einem der vorstehenden Ansprüche, bei dem das maschinengelernte System unter Verwendung von Sondenpositionen trainiert wurde, die unter Benutzeraufsicht erhalten wurden, um der Eingabegeometrie zu entsprechen.

7. System zur Platzierung von Beleuchtungssonden nach einem der vorstehenden Ansprüche, bei dem
das maschinengelernte System unter Verwendung von Zielpositionen für die Sonden trainiert wurde, die automatisch unter Verwendung eines Schemas zur Bewertung der Position der Beleuchtungssonde erzeugt wurden, das Schema umfassend:
Auswählen einer Verteilung der Positionen der Beleuchtungssonden innerhalb des mindestens einen Teils der virtuellen Umgebung entsprechend der Eingabegeometrie;
Rendern eines Bildes von mindestens einem Teil der virtuellen Umgebung unter Verwendung der ausgewählten Verteilung der Positionen der Beleuchtungssonden von einem vorbestimmten Standpunkt aus, der einem Referenzstandpunkt entspricht;
Vergleichen des gerenderten Bildes mit dem Bild der Grundwahrheit von mindestens einem Teil der virtuellen Umgebung aus demselben Referenzstandpunkt, um einen Bildfehler zu bestimmen; und
Ändern der Verteilung mindestens einiger Positionen der Beleuchtungssonden, wenn der Fehler ein erstes vorgegebenes Kriterium nicht erfüllt, und
Zuordnen der Verteilung der Positionen der Beleuchtungssonden zu dem mindestens einen Teil der virtuellen Umgebung, wenn der Fehler ein zweites vorgegebenes Kriterium erfüllt.

8. System zur Platzierung von Beleuchtungssonden nach einem der Ansprüche 1 bis 6, bei dem
das maschinengelernte System unter Verwendung von Zielpositionen für die Sonden trainiert wurde, die automatisch unter Verwendung eines Schemas zur Bewertung der Position der Beleuchtungssonde erzeugt wurden, das Schema umfassend:
Auswählen einer Verteilung der Positionen der Beleuchtungssonden innerhalb des mindestens einen Teils der virtuellen Umgebung entsprechend der Eingabegeometrie;
Rendern eines Bildes von mindestens einem Teil der virtuellen Umgebung unter Verwendung der ausgewählten Verteilung der Positionen der Beleuchtungssonden;
Präsentieren des gerenderten Bildes an ein weiteres maschinengelerntes System, das selbst darauf trainiert ist, die Beleuchtung von Bildern basierend auf einem Satz von Beispielbildern zu bewerten; und
Erhalten eines Bildfehlerwertes von dem weiteren maschinengelernten System.

9. System zur Platzierung von Beleuchtungssonden nach Anspruch 7 oder 8, bei dem die Verteilung der Positionen der Beleuchtungssonden durch eines oder mehrere aus der Liste ausgewählt geändert wird, bestehend aus:
i. ceiner zufälligen Umverteilung von mindestens einigen der Positionen der Beleuchtungssonden;
ii. einer zufälligen Störung mindestens einiger Positionen der Beleuchtungssonden um bis zu einem bestimmten Wert; und
iii. einer Umpositionierung mindestens einiger der Positionen der Beleuchtungssonden innerhalb eines Bereichs von Richtungen, die auf die vorherige effektive Richtung einer Positionsänderung einer Sonde zentriert sind, wenn die Änderung einer Sonde zu ihrer aktuellen Position mit einer Verringerung des Bildfehlers korrespondiert.

10. System zur Platzierung von Beleuchtungssonden nach einem der Ansprüche 7 bis 9, bei dem die Verteilung der Positionen der Beleuchtungssonden durch Einschließen oder Ausschließen von Beleuchtungssonden bei dem Rendern des Bildes verändert wird.

11. System zur Bearbeitung virtueller Inhalte, umfassend:
das System zur Platzierung von Beleuchtungssonden nach einem der vorstehenden Ansprüche;
einen Renderprozessor, der in der Lage ist, ein Bild mindestens eines Teils der virtuellen Umgebung unter Verwendung einer vom maschinengelernten System erzeugten zugehörigen Verteilung der Positionen der Beleuchtungssonden zu rendern; und
einen Ausgabeprozessor, der das gerenderte Bild zur Anzeige an einen Benutzer ausgibt.

12. Verfahren zum Schätzen der Positionen von Beleuchtungssonden in einer virtuellen Umgebung, umfassend die folgenden Schritte:
Empfangen von Geometrie von mindestens einem Teil der virtuellen Umgebung und deren Vorbereitung für die Eingabe in ein maschinengelerntes System;
Bereitstellen der Eingabegeometrie für ein maschinengelerntes System, das darauf trainiert wurde, die Positionen der Beleuchtungssonden auszugeben; und Trainieren des maschinellen Lernsystems umfasst Folgendes:
für ein gegebenes Trainingspaar aus Eingaben und Ausgaben, Erzeugen eines Referenzbildes, in dem eine virtuelle Szene vollständig gerendert wird, einschließlich Beleuchtung und optional Reflexion; und
automatisches Annähern an das Referenzbild unter Verwendung globaler Beleuchtungssonden und optionaler Reflexionssonden während eines Renderns; und
Bestimmen einer Anzahl von Sondenverteilungen, bei denen die entsprechenden gerenderten Bilder für dieselbe Szene bis zu einem Schwellenwert mit dem Referenzbild übereinstimmen; und
Verwenden einiger oder aller dieser Verteilungen für das Trainieren des maschinellen Lernsystems; und
Zuordnen der Positionen der ausgegebenen Beleuchtungssonden zu mindestens einem Teil der virtuellen Umgebung für das anschließende Rendern.

13. Verfahren zum Trainieren eines maschinengelernten Systems zur Verwendung in einem der vorstehenden Ansprüche, umfassend die folgenden Schritte:
automatisches Erzeugen eines Trainingssatzes von Eingabegeometrie und entsprechenden Zielsondenpositionen unter Verwendung eines Schemas zur Bewertung von Beleuchtungssondenpositionen, das Schema umfassend:
Auswählen einer Verteilung der Positionen der Beleuchtungssonden innerhalb des mindestens einen Teils der virtuellen Umgebung entsprechend der Eingabegeometrie;
Rendern eines Bildes von mindestens einem Teil der virtuellen Umgebung unter Verwendung der ausgewählten Verteilung der Positionen der Beleuchtungssonden von einem vorbestimmten Standpunkt aus, der einem Referenzstandpunkt entspricht;
Vergleichen des gerenderten Bildes mit dem Bild der Grundwahrheit von mindestens einem Teil der virtuellen Umgebung aus demselben Referenzstandpunkt, um einen Bildfehler zu bestimmen; und
Ändern der Verteilung mindestens einiger Positionen der Beleuchtungssonden, wenn der Fehler ein erstes vorgegebenes Kriterium nicht erfüllt, und
Zuordnen der Verteilung der Positionen der Beleuchtungssonden zu dem mindestens einen Teil der virtuellen Umgebung, wenn der Fehler ein zweites vorgegebenes Kriterium erfüllt; und
Trainieren des maschinengelernten Systems unter Verwendung der Eingabegeometrie und der Verteilungen der Positionen der Beleuchtungssonden, die mit dem entsprechenden mindestens Teil der virtuellen Umgebung verbunden sind.

14. Verfahren nach Anspruch 13, bei dem die Verteilung der Positionen der Beleuchtungssonden durch eines oder mehrere aus der Liste ausgewählt geändert wird, bestehend aus:
i. ceiner zufälligen Umverteilung von mindestens einigen der Positionen der Beleuchtungssonden;
ii. einer zufälligen Störung mindestens einiger Positionen der Beleuchtungssonden um bis zu einem bestimmten Wert; und
iii. einer Umpositionierung mindestens einiger der Positionen der Beleuchtungssonden innerhalb eines Bereichs von Richtungen, die auf die vorherige effektive Richtung einer Positionsänderung einer Sonde zentriert sind, wenn die Änderung einer Sonde zu ihrer aktuellen Position mit einer Verringerung des Bildfehlers korrespondiert.

15. Computerprogramm, umfassend computerausführbare Anweisungen, die, wenn sie von einem Computersystem ausgeführt werden, das Computersystem veranlassen, das Verfahren nach einem der Ansprüche 12 bis 14 durchzuführen.

## Revendications

1. Système de mise en place de sonde d'éclairage destiné à estimer des positions de sonde d'éclairage à l'intérieur d'un environnement virtuel comprenant :
un processeur d'entrée géométrique configuré pour recevoir une géométrie d'au moins une partie de l'environnement virtuel et la préparer afin d'introduire dans un système d'apprentissage automatique ;
un processeur configuré pour mettre en œuvre le système d'apprentissage automatique, qui a été entraîné pour délivrer en sortie des positions de sonde d'éclairage lors de la réception d'une géométrie introduite de l'au moins une partie de l'environnement virtuel ; et l'entraînement du système d'apprentissage automatique comprend :
pour une paire d'entrées et de sorties d'entraînement donnée, la génération d'une image de réalité de terrain dans laquelle une scène virtuelle est rendue entièrement, qui comporte l'éclairage et, optionnellement, la réflexion ; et
l'approximation automatique de l'image de réalité de terrain à l'aide de sondes à illumination globale et, optionnellement, de sondes à réflexion pendant un rendu ; et
la détermination d'un nombre de répartitions de sonde pour lesquelles les images rendues correspondantes pour la même scène correspondent à l'image de réalité de terrain à un degré seuil ; et
l'utilisation d'une partie ou de la totalité de ces répartitions pour l'entraînement du système d'apprentissage automatique ; et
un processeur d'association configuré pour associer les positions de sonde d'éclairage délivrées en sortie à l'au moins une partie de l'environnement virtuel en vue d'un rendu ultérieur.

2. Système de mise en place de sonde d'éclairage selon la revendication 1, dans lequel les sondes d'éclairage comprennent l'un ou plusieurs éléments sélectionnés dans la liste constituée de :
i au moins des sondes à illumination globale ; et
ii. des sondes à illumination globale et des sondes à réflexion.

3. Système de mise en place de sonde d'éclairage selon l'une quelconque revendication précédente, dans lequel la géométrie introduite comprend l'un ou plusieurs éléments sélectionnés dans la liste constituée de :
i. une structure de graphe de scène ; et
ii. une représentation à dimension réduite de la géométrie introduite.

4. Système de mise en place de sonde d'éclairage selon l'une quelconque revendication précédente, dans lequel l'entrée dans le système d'apprentissage automatique comprend également l'un ou plusieurs éléments sélectionnés dans la liste constituée de :
i. des métadonnées géométriques ;
ii. des métadonnées d'occlusion géométrique ; et
iii. des informations de couleur dérivées de l'environnement virtuel correspondant à la géométrie introduite.

5. Système de mise en place de sonde d'éclairage selon l'une quelconque revendication précédente, dans lequel la sortie à partir du système d'apprentissage automatique comprend également l'un ou plusieurs éléments sélectionnés dans la liste constituée de :
i. des métadonnées de sonde ; et
ii. un rayon d'influence de sonde.

6. Système de mise en place de sonde d'éclairage selon l'une quelconque revendication précédente, dans lequel le système d'apprentissage automatique a été entraîné à l'aide de positions de sonde obtenues sous la supervision d'un utilisateur pour correspondre à la géométrie introduite.

7. Système de mise en place de sonde d'éclairage selon l'une quelconque revendication précédente, dans lequel
le système d'apprentissage automatique a été entraîné à l'aide de positions de sonde cible générées automatiquement à l'aide d'un schéma d'évaluation de position de sonde d'éclairage, le schéma comprenant :
la sélection d'une répartition de positions de sonde d'éclairage à l'intérieur de l'au moins une partie de l'environnement virtuel correspondant à la géométrie introduite ;
le rendu, à partir d'un point de vue prédéterminé correspondant à un point de vue de référence, d'une image de l'au moins une partie de l'environnement virtuel à l'aide de la répartition sélectionnée de positions de sonde d'éclairage ;
la comparaison de l'image rendue avec l'image de réalité de terrain de l'au moins une partie de l'environnement virtuel à partir du même point de vue de référence afin de déterminer une erreur d'image ; et
la modification de la répartition d'au moins certaines positions de sonde d'éclairage si l'erreur ne répond pas à un premier critère prédéterminé, et
l'association de la répartition de positions de sonde d'éclairage à l'au moins une partie de l'environnement virtuel si l'erreur répond à un second critère prédéterminé.

8. Système de mise en place de sonde d'éclairage selon l'une quelconque des revendications 1 à 6, dans lequel
le système d'apprentissage automatique a été entraîné à l'aide de positions de sonde cible générées automatiquement à l'aide d'un schéma d'évaluation de position de sonde d'éclairage, le schéma comprenant :
la sélection d'une répartition de positions de sonde d'éclairage à l'intérieur de l'au moins une partie de l'environnement virtuel correspondant à la géométrie introduite ;
le rendu d'une image de l'au moins une partie de l'environnement virtuel à l'aide de la répartition sélectionnée de positions de sonde d'éclairage ;
la présentation de l'image rendue à un autre système d'apprentissage automatique lui-même entraîné pour évaluer l'éclairage d'images sur la base d'un ensemble d'images d'exemple ; et
l'obtention d'une valeur d'erreur d'image à partir de l'autre système d'apprentissage automatique.

9. Système de mise en place de sonde d'éclairage selon la revendication 7 ou la revendication 8, dans lequel la répartition de positions de sonde d'éclairage est modifiée par l'un ou plusieurs éléments sélectionnés dans la liste constituée de :
i. une nouvelle répartition aléatoire d'au moins certaines des positions de sonde d'éclairage ;
ii. une perturbation aléatoire d'au moins certaines des positions de sonde d'éclairage jusqu'à une quantité prédéterminée ; et
iii. un repositionnement d'au moins certaines des positions de sonde d'éclairage à l'intérieur d'une gamme de directions centrées sur la direction effective précédente d'un changement de position d'une sonde, si le changement d'une sonde par rapport à sa position actuelle correspond à une réduction de l'erreur d'image.

10. Système de mise en place de sonde d'éclairage selon l'une quelconque des revendications 7 à 9, dans lequel la répartition de positions de sonde d'éclairage est modifiée par inclusion ou exclusion de sondes d'éclairage lors du rendu de l'image.

11. Système d'édition de contenu virtuel, comprenant :
le système de mise en place de sonde d'éclairage selon l'une quelconque revendication précédente ;
un processeur de rendu permettant de rendre une image de l'au moins une partie de l'environnement virtuel à l'aide d'une répartition associée de positions de sonde d'éclairage générée par le système d'apprentissage automatique ; et
un processeur de sortie permettant de délivrer en sortir l'image rendue pour l'afficher à un utilisateur.

12. Procédé d'estimation de positions de sonde d'éclairage à l'intérieur d'un environnement virtuel, comprenant les étapes consistant à :
recevoir une géométrie d'au moins une partie de l'environnement virtuel et la préparer afin d'introduire dans un système d'apprentissage automatique ;
fournir la géométrie introduite à un système d'apprentissage automatique qui a été entraîné pour délivrer en sortir des positions de sonde d'éclairage ; et l'entraînement du système d'apprentissage automatique comprend :
pour une paire d'entrées et de sorties d'entraînement donnée, la génération d'une image de réalité de terrain dans laquelle une scène virtuelle est rendue entièrement, qui comporte l'éclairage et, optionnellement, la réflexion ; et
l'approximation automatique de l'image de réalité de terrain à l'aide de sondes à illumination globale et, optionnellement, de sondes à réflexion pendant un rendu ; et
la détermination d'un nombre de répartitions de sonde pour lesquelles les images rendues correspondantes pour la même scène correspondent à l'image de réalité de terrain à un degré seuil ; et
l'utilisation d'une partie ou de la totalité de ces répartitions pour l'entraînement du système d'apprentissage automatique ; et
associer les positions de sonde d'éclairage délivrées en sortie à l'au moins une partie de l'environnement virtuel en vue d'un rendu ultérieur.

13. Procédé d'entraînement d'un système d'apprentissage automatique à utiliser dans l'une quelconque des revendications précédentes, comprenant les étapes consistant à :
générer automatiquement un ensemble d'entraînement de géométrie introduite et des positions de sonde cible correspondantes à l'aide d'un schéma d'évaluation de position de sonde d'éclairage, le schéma comprenant :
la sélection d'une répartition de positions de sonde d'éclairage à l'intérieur de l'au moins une partie de l'environnement virtuel correspondant à la géométrie introduite ;
le rendu, à partir d'un point de vue prédéterminé correspondant à un point de vue de référence, d'une image de l'au moins une partie de l'environnement virtuel à l'aide de la répartition sélectionnée de positions de sonde d'éclairage ;
la comparaison de l'image rendue avec l'image de réalité de terrain de l'au moins une partie de l'environnement virtuel à partir du même point de vue de référence afin de déterminer une erreur d'image ; et
la modification de la répartition d'au moins certaines positions de sonde d'éclairage si l'erreur ne répond pas à un premier critère prédéterminé, et
l'association de la répartition de positions de sonde d'éclairage à l'au moins une partie de l'environnement virtuel si l'erreur répond à un second critère prédéterminé ; et
l'environnement du système d'apprentissage automatique à l'aide d'une géométrie introduite et de répartitions des positions de sonde d'éclairage associées à l'au moins une partie correspondante de l'environnement virtuel.

14. Procédé selon la revendication 13, dans lequel la répartition de positions de sonde d'éclairage est modifiée par l'un ou plusieurs éléments sélectionnés dans la liste constituée de :
i. une nouvelle répartition aléatoire d'au moins certaines des positions de sonde d'éclairage ;
ii. une perturbation aléatoire d'au moins certaines des positions de sonde d'éclairage jusqu'à une quantité prédéterminée ; et
iii. un repositionnement d'au moins certaines des positions de sonde d'éclairage à l'intérieur d'une gamme de directions centrées sur la direction effective précédente d'un changement de position d'une sonde, si le changement d'une sonde par rapport à sa position actuelle correspond à une réduction de l'erreur d'image.

15. Programme d'ordinateur comprenant des instructions exécutables par un ordinateur qui, lorsqu'elles sont exécutées par un système d'ordinateur, amènent le système d'ordinateur à effectuer le procédé selon l'une quelconque des revendications 12 à 14.
